(19) Europäisches Patentamt

European Patent Office

Office européen des brevets

(11) **EP 1 232 530 B1**

(12) **EUROPÄISCHE PATENTSCHRIFT**

(45) Veröffentlichungstag und Bekanntmachung des Hinweises auf die Patenterteilung:
**24.05.2006 Patentblatt 2006/21**

(21) Anmeldenummer: **00987011.4**

(22) Anmeldetag: **13.10.2000**

(51) Int Cl.:
*H01L 31/108* (2006.01)      *H01L 31/032* (2006.01)

(86) Internationale Anmeldenummer:
**PCT/DE2000/003727**

(87) Internationale Veröffentlichungsnummer:
**WO 2001/027571 (19.04.2001 Gazette 2001/16)**

(54) **HALBLEITERBAUELEMENT, ELEKTRONISCHES BAUTEIL, SENSORSYSTEM UND VERFAHREN ZUR HERSTELLUNG EINES HALBLEITERBAUELEMENTES**

SEMICONDUCTOR COMPONENT, ELECTRONIC COMPONENT, SENSOR SYSTEM AND METHOD FOR PRODUCING A SEMICONDUCTOR COMPONENT

COMPOSANT SEMI-CONDUCTEUR, COMPOSANT ELECTRONIQUE, SYSTEME DE DETECTION ET PROCEDE POUR LA PRODUCTION D'UN COMPOSANT SEMI-CONDUCTEUR

(84) Benannte Vertragsstaaten:
**AT BE CH DE FR GB LI**

(30) Priorität: **15.10.1999 DE 19951207**

(43) Veröffentlichungstag der Anmeldung:
**21.08.2002 Patentblatt 2002/34**

(73) Patentinhaber: **Honeywell Technologies Sarl
1024 Ecublens (CH)**

(72) Erfinder:
- **WEISS, Tilman
  10963 Berlin (DE)**
- **THIEDIG, Christoph
  10119 Berlin (DE)**
- **LANGER, Stefan
  15738 Zeuthen (DE)**
- **HILT, Oliver
  15566 Schöneiche (DE)**
- **KÖRNER, Hans, Georg
  15236 Frankfurt/Oder (DE)**
- **STAHN, Sebastian
  10715 Berlin (DE)**
- **SWIENTEK, Stephan
  15745 Wildau (DE)**

(74) Vertreter: **Gross, Felix et al
Patentanwälte
Maikowski & Ninnemann
Postfach 15 09 20
10671 Berlin (DE)**

(56) Entgegenhaltungen:
EP-A- 0 364 597          EP-A- 1 017 110
WO-A-94/00887          DE-A- 4 306 407
DE-A- 19 951 207          US-A- 5 446 286

- SOU ET AL: "Photoresponse stideis of ZnSSe visible-blind ultraviolet detectors: a comparison to ZnSTe detectors" APPLIED PHYSICS LETTERS,US,AMERICAN INSTITUTE OF PHYSICS. NEW YORK, Bd. 75, Nr. 23, 6. Dezember 1999 (1999-12-06), Seiten 3707-3709, XP002137215 ISSN: 0003-6951
- PATENT ABSTRACTS OF JAPAN vol. 1998, no. 04, 31. März 1998 (1998-03-31) & JP 09 325068 A (OSAKA GAS CO LTD), 16. Dezember 1997 (1997-12-16)
- PATENT ABSTRACTS OF JAPAN vol. 016, no. 027 (E-1158), 23. Januar 1992 (1992-01-23) & JP 03 241777 A (MITSUI TOATSU CHEM INC), 28. Oktober 1991 (1991-10-28)
- NEGAMI T. ET AL: 'CuInS2 thin-films solar cells fabricated by sulfurization of oxide precursors' SOLAR ENERGY MATERIALS AND SOLAR CELLS Bd. 49, 1997, AMSTERDAM, Seiten 343 - 348, XP004099608
- MALIK A. ET AL: 'Nex UV-enhanced solar blind optical sensors based on monocrystalline zinc sulphide' SENSORS AND ACTUATORS A Bd. 67, 1998, AMSTERDAM, Seiten 68 - 71, XP004130113

**Beschreibung**

Die Erfindung betrifft ein Halbleiterbauelement nach dem Oberbegriff des Anspruchs 1, ein elektronische Bauteil nach Anspruch 17 ein Sensorsystem nach dem Oberbegriff des Anspruchs 18 und ein Verfahren zur Herstellung eines Halbleiterbauelements nach dem Oberbegriff des Anspruchs 26.

Bekannt sind Halbleiterbauelemente für die Detektion elektromagnetischer Strahlung aus einkristallinem Silizium, einkristallinen Verbindungshalbleitern oder aus Siliziumcarbid. Nachteilig sind dabei insbesondere die hohen Kosten für die Herstellung des einkristallinen Materials.

Auch ist Silizium für einen breiten Spektralbereich elektromagnetischer Strahlung (nahe IR- bis UV-Strahlung) sensitiv. Da bei vielen technischen Anwendungsgebieten Strahlung in einem breiten Wellenlängenbereich auftritt, werden z.B. Meßergebnisse für bestimmte Strahlungsbereiche verfälscht.

Neben Elementhalbleitern sind auch Verbindungshalbleiter, wie z.B. Galliumarsenid bekannt. Auch diese Verbindungshalbleiter sind schwer zu verarbeiten.

Aus der DE 43 06 407 A1 ist ein Detektor für elektromagnetische Strahlung bekannt, in dem hochporöses Titandioxid als Trägermaterial für einen flüssigen Elektrolyten und einen Farbstoff verwendet wird. Nachteilig ist dabei die Verwendung eines Zweiphasen (fest-flüssig) Detektors, der bei der Herstellung Schwierigkeiten bereitet.

Dokument "New UV-enhanced solar blind optical sensors based on monocrystalline zinc sulphide", A.Malik *et al.* Sensors and Actuators A67, 68-71 (1998), beschreibt ein Halbleiterbauelement zur Detektion von UV-Strahlung mit einem Schichtenstapel aus einem Metallchalkogenid-Verbindungshalbleiter, der einen Schottky-Kontakt mit einem transparenten Metall bildet.

Der vorliegenden Erfindung liegt die Aufgabe zugrunde, ein Halbleiterbauelement zur Detektion elektromagnetischer Strahlung zu schaffen, das in kostengünstiger Weise herstellbar ist und in besonders definierter Weise auf elektromagnetische Strahlungen reagiert. Ferner ist es die Aufgabe, ein elektronisches Bauteil und ein Sensorsystem mit einem solchen Halbleiterbauelement, sowie ein Verfahren zur Herstellung des Halbleiterbauelements zu schaffen.

Diese Aufgabe wird erfindungsgemäß durch ein Halbleiterbauelement mit den Merkmalen des Anspruchs 1 gelöst.

Durch die Herstellung eines Kontaktes zwischen einem Metall und einem Halbleiter wird ein Schottky-Kontakt hergestellt.

Dieser Kontakt sorgt für die Trennung der Ladungsträgerpaare, die bei Eindringen elektromagnetischer Strahlung (z.B. UV-Strahlung) in dem Halbleiter erzeugt werden.

Da der Halbleiter mindestens einen nanokristallinen Metallchalkogenid-Verbindungshalbleiter als optisches Absorbermaterial aufweist oder ganz aus ihm besteht, ist der Halbleiter einfacher zu verarbeiten als Silizium oder andere Verbindungshalbleiter, so daß die Herstellung eines solchen Bauteils kostengünstiger ist. Auch wird erreicht, daß keine flüssige Phase verwendet werden muß. Durch die Verwendung von mindestens einem Metallchalkogenid-Verbindungshalbleiter wird auch erreicht, daß elektromagnetische Strahlung in bestimmten Wellenlängenbereichen (z.B. sichtbares Licht) nicht detektiert wird, so daß dieser Bereich ausgeklammert wird. Dadurch kann dieser Bereich nicht die Messung einer Strahlung in einem anderen Wellenlängenbereich (z.B. UV-Strahlung) beeinträchtigen.

Vorteilhaft ist ein Halbleiter, der eine Mischung aus mindestens zwei Metallchalkogenid-Verbindungshalbleitern oder eine Schichtfolge aus mindestens zwei Metallchalkogenid-Verbindungshalbleitern aufweist.

Besonders vorteilhaft ist es, wenn ein erster Metallchalkogenid-Verbindungshalbleiter eine hohe Strahlungsabsorptionsfähigkeit aufweist und ein zweiter Metallchalkogenid-Verbindungshalbleiter eine hohe Ladungsträger-Leitfähigkeit aufweist. Da ein Verbindungshalbleiter häufig nicht alle erforderlichen Eigenschaften (z.B. gute optische Absorptionseigenschaften, gute Leitfähigkeit) in sich vereinigt, kann durch eine Kombination von unterschiedlichen Metallchalkogenid-Verbindungshalbleitern eine verbesserte Gesamtwirkung erreicht werden.

Besonders vorteilhaft ist es, wenn mindestens ein Halbleiter ein Metallchalkogenid-Verbindungshalbleiter $TiO_2$, $ZnO$, $ZnS$, $MgS$, $SnO_2$, $SiO_2$, $ZrO_2$, $PbO$, $NiO$, $Nb_2O_5$, $Ta_2O_5$, $Fe_2O_3$ oder $In_2O_3$ ist, da diese Verbindungshalbleiter leicht herstellbar sind. Diese Metallchalkogenid-Halbleiter können auch in beliebigen Mischungen miteinander in erfindungsgemäßen Halbleiterbauelementen verwendet werden.

In einer weiteren vorteilhaften Weiterbildung des erfindungsgemäßen Halbleiterbauelements weist mindestens ein Halbleiter eine selektive Empfindlichkeit für elektromagnetische Strahlung mit einer Wellenlänge von kleiner als 400nm auf. Besonders vorteilhaft ist es, wenn mindestens ein Halbleiter eine maximale Selektivität für elektromagnetische Strahlung im Wellenlängenbereich zwischen 300 und 360nm aufweist. Damit ist eine effizientes Detektieren von UV-Strahlung möglich.

In einer vorteilhaften Ausgestaltung des erfindungsgemäßen Halbleiterbauelements ist der Halbleiter als Halbleiterschicht auf einem Substrat angeordnet.

In einer weiteren vorteilhaften Ausgestaltung ist zwischen der Halbleiterschicht und dem Substrat mindestens eine Zwischenschicht angeordnet.

Vorzugsweise weist die Halbleiterschicht eine Schichtdicke von weniger als $1\mu m$ auf. Ebenfalls ist es vorteilhaft, wenn die Halbleiterschicht im wesentlichen eine Korngröße von kleiner als 20nm, insbesondere kleiner als 10nm aufweist. Die Korngröße ist dabei ein Maß für die Porosität oder Rauheit der Halbleiterschicht. Dabei ist eine glatte, nicht poröse Oberfläche von besonderer Bedeutung, da durch eine poröse Oberfläche im Übergang zur Metallschicht der Ladungstransport in diesem Bereich erschwert werden würde.

Es ist besonders vorteilhaft, wenn die Oberfläche der Halbleiterschicht optisch glatt ist. Auch dadurch wird ein besonders guter Kontakt zu angrenzenden Schichten gewährleistet.

Mit Vorteil ist bei einem erfindungsgemäßen Halbleiterbauelement die Halbleiterschicht mit einer elektrischen Kontaktschicht leitend verbunden. Damit läßt sich eine besonders kompakte Bauform erreichten.

Ferner ist es zur Erhöhung der Ladungsträgeranzahl vorteilhaft, die Halbleiterschicht mit Niob und / oder Tantal zu dotieren.

Mit Vorteil ist das Metall im Schottky-Kontakt Platin, Palladium, Nickel, Gold oder Silber, da diese Metalle über eine besonders hohe Austrittsarbeit verfügen.

Besonders vorteilhaft ist es, wenn das Metall als Metallschicht auf der Halbleiterschicht angeordnet ist. Auf diese Weise läßt sich ein Halbleiterbauelement bei großer Oberfläche in besonders kompakter Bauweise ausführen.

In einer weiteren vorteilhaften Ausgestaltung des erfindungsgemäßen Halbleiterbauelements ist die Metallschicht für elektromagnetische Strahlung transparent. Dadurch wird der empfindliche Teil der Raumladungszone bestrahlt, die im Grenzbereich zwischen Metallschicht und Halbleiterschicht liegt. Eine transparente Metallschicht stellt einen Kompromiß zwischen der notwendigen Leitfähigkeit und der erforderlichen Transparenz dar.

Mit Vorteil ist die Halbleiterschicht mit einer elektrischen Kontaktschicht leitend verbunden. Vorteilhafterweise weist die Kontaktschicht fluordotierte $SnO_2$, $SnO_2/In_2O_3$-, ZnO, aluminium-dotiertes ZnO, Zink- oder Aluminium auf oder ist daraus gebildet, da hierdurch besonders gute Leitungseigenschaften im Bereich Kontaktschicht und Halbleiterschicht erzielt werden. Durch die hohe Güte der Oberfläche (d.h. geringe Korngröße, geringe Porosität) der Halbleiterschicht wird ein besonders guter Ladungsübergang zur Kontaktschicht sichergestellt.

Besonders vorteilhaft ist es, wenn das Substrat aus Metall gebildet ist, dieses dann unter Einschluß seines eigenen Oxides einen leitfähigen Rückkontakt bildet. Eine solche kompakte Anordnung ermöglicht den leichten Einbau in ein Gerät, z.B. ein Meßgerät.

Eine besonders vorteilhafte Ausgestaltung des erfindungsgemäßen Halbleiterbauelements ist so aufgebaut, daß auf dem Substrat eine leitende Kontaktschicht, darauf eine Halbleiterschicht, insbesondere eine $TiO_2$-Schicht als Halbleiterschicht und darauf eine Platin-Schicht als Metallschicht angeordnet ist. Ein solcher Aufbau ermöglicht einen direkt anschließbaren Rückkontakt und die Nutzung der gesamten Bauelementoberfläche als optisch wirksamen Schottky-Kontakt. Ein solcher Aufbau ist kompakt und kostengünstig herstellbar und weist eine hohe Sensitivität gegenüber UV-Strahlen und eine geringe Sensitivität gegenüber sichtbarem Licht auf.

Auch ist es vorteilhaft, auf dem Substrat eine Platin-Schicht als Metallschicht, darauf eine Halbleiterschicht, insbesondere eine $TiO_2$-Schicht als Halbleiterschicht und darauf eine transparente Kontaktschicht anzuordnen. Bei einer solchen Schichtung dient das Substrat gleichzeitig als Sicht- und Schutzfenster, was die Integration dieses Halbleiterbauelements in andere Geräte erleichtert.

Eine weitere vorteilhafte Ausgestaltung des erfindungsgemäßen Halbleiterbauelements weist als Substrat einen Glaskörper, insbesondere Quarzglas, mit mindestens einer ebenen Fläche auf. Auf der mindestens einen ebenen Fläche lassen sich Beschichtungen in einfacher Weise vornehmen. Quarzglas weist eine hohe Durchlässigkeit für UV-Strahlung auf.

Mit Vorteil weist ein erfindungsgemäßes Halbleiterbauelement ein Substrat auf, das für UV-Strahlung transparent ist.

Vorteilhaft ist es, wenn bei einer Bestrahlung des erfindungsgemäßen Halbleiterbauelements mit einer elektromagnetischen Strahlung, im Halbleiterbauelement ein Strom zwischen dem Metall und der elektrischen Kontaktschicht fließt. Der Stromfluß oder die dabei generierte Spannung kann zur Messung der einfallenden elektromagnetischen Strahlung verwendet werden.

Die Aufgabe wird auch durch ein elektronisches Bauteil mit den Merkmalen des Anspruchs 17 gelöst. Durch die Verwendung eines Halbleiterbauelements mit einem Verbindungshalbleiter wird eine elektronischen Bauteil, z.B. zur Anordnung auf einer Schaltungsplatine, das kostengünstig herstellbar ist und eine selektive Sensitivität für elektromagnetische Strahlung aufweist.

Weiterhin wird die Aufgabe durch ein erfindungsgemäßes Sensorsystem für elektromagnetische Strahlung mit den Merkmalen des Anspruchs 18 gelöst. Durch den Einsatz eines Halbleiterbauelements mit einem Metallchalkogenid-Verbindungshalbleiter kann elektromagnetische Strahlung in einem definierten Bereich detektiert werden. Insbesondere ist es vorteilhaft, wenn der Halbleiter sensitiv für UV-Strahlung ist.

Ein Sensorsystem zur Detektion von UV-Strahlung ist in vielen Bereichen einsetzbar. So muß aus sicherheitstechnischen Gründen in Heizungsanlagen die Flamme überwacht werden. Hierzu wird die UV-Strahlung im Brennraum gemessen. Die spektrale Verteilung der UV-Strahlung gibt Aufschluß über die Güte der Verbrennung. Ein solches Sensorsystem kann für eine Regelung der Luftüberschußzahl in einer Heizungsanlage eingesetzt werden.

Da von dem Brennraum einer Heizungsanlage aber stets auch erhebliche Strahlungsanteile im sichtbaren und IR-Bereich ausgehen, ist es besonders vorteilhaft, wenn das Sensorsystem eine hohe Selektivität für UV-Strahlen aufweist. Auch in anderen Einsatzgebieten, wie z.B. bei der Messung von UV-Strahlung in Solarien, bei der Untersuchung der künstlichen Alterung von Materialproben, Lebensmittelinspektionen, spektroskopischen Untersuchungen oder der Wasseraufbereitung mit UV-Strahlen kommt es auf dieses Selektivität an.

Dabei ist es besonders vorteilhaft, wenn die maximale Sensitivität des Halbleiters in einem Wellenlängenbereich von 300 bis 360nm liegt. Vorteilhaft ist es auch, wenn Halbleiter insensitiv für sichtbares Licht, insbesondere mit Wellenlängen oberhalb 400nm, und / oder IR-Strahlung ist.

Eine besonders vorteilhafte Ausgestaltung des erfindungsgemäßen Sensorsystems ist es, wenn es in einem tragbaren Gerät, insbesondere einem Handgerät, einer tragbaren Uhr, einem Anstecker oder einem Fahrradcomputer angeordnet ist. Damit steht ein transportables und kostengünstiges Gerät zur Verfügung, mit dem sich z.B. die UV-Strahlung beim Sonnenbaden am Strand oder im Solarium messen läßt.

Dabei ist es vorteilhaft, wenn das Sensorsystem ein Mittel zur Erfassung einer kumulierten Strahlungsdosis aufweist, mit dem die empfangene Strahlendosis erfaßbar ist. Besonders vorteilhaft ist es, wenn ein Auswertungsmittel, eine Differenz der kumulierten Strahlungsdosis zu einem vorgebbaren Wert einer Strahlungsdosis ermittelt, da anhand dieser Differenz beurteilbar ist, ein bestimmter Grenzwert überschritten wurde. Vorteilhafterweise zeigt das Auswertungsmittel die Differenz automatisch optisch und / oder akustisch an, um z.B. einen Benutzer auf das Über- oder Unterschreiten eines Grenzwertes hinzuweisen.

Besonders vorteilhaft ist es, wenn das Auswertungsmittel gemessene Ausreißer der Strahlungsdosis detektiert. Solche Ausreißer können z.B. bei einer Bestrahlung mit UV-Licht auf eine übermäßige Belastung der Haut hindeuten. Zur Vermeidung einer Verfälschung der aufkumulierten Strahlungsdosis ist es vorteilhaft, wenn das Auswertungsmittel die Ausreißer bei der Kumulierung der Strahlungsdosis nicht berücksichtigt. Gerade bei UV-Strahlung kann ein Langzeit-Defizit nicht durch eine kurzzeitige, intensive Bestrahlung ausgeglichen werden.

Bei einer weiteren vorteilhaften Fortbildung des erfindungsgemäßen Sensorsystems weist das Auswertungsmittel ein Korrekturmittel auf, um den tatsächlichen Einstrahlungs-Querschnitt des Sensorsystem auf einen Eintrahlungsquerschnitt einer Person umzurechnen. Damit kann z.B. das Sensorsystem in einer Uhr angeordnet sein und dennoch Aussagen über die Strahlungsexposition des Trägers der Uhr machen.

Die der Erfindung zugrundeliegende Aufgabe wird auch durch ein erfindungsgemäßes Verfahren mit den Merkmalen des Anspruchs 26 gelöst.

Dadurch, daß ein Substrat mit einer Lösung in Kontakt gebracht wird, in der ein Precursor mindestens eines Metallchalkogenid-Verbindungshalbleiters gelöst und / oder suspendiert ist, läßt sich in einfacher Weise eine Halbleiterschicht auf das Substrat aufbringen. Dabei wird unter einem Substrat auch ein Gegenstand verstanden, der vor dem Inkontaktbringen bereits mit einer anderen Schicht (z.B. TCO) beschichtet wurde, so daß erfindungsgemäße Verfahren die Beschichtung auf dem Substrat direkt und / oder auf der vorhanden Beschichtung des Substrats anbringt. Unter einem

Precursor wird hier eine Substanz verstanden, die nach mindestens einer chemischen Reaktion und / oder mindestens einer physikalischen Behandlung (z.B. Erhitzen) ein Metallchalkogenid-Verbindungshalbleiter bildet.

Vorteilhaft ist es dabei, wenn das Substrat nacheinander mit mindestens zwei verschiedenen Precursor-Lösungen in Kontakt gebracht wird, da damit eine Kombination verschiedener Beschichtungen ermöglicht wird.

Dabei ist es besonders vorteilhaft, wenn die Lösung mindestens einen Precursor der Metallchalkogenid-Verbindungshalbleiter $TiO_2$, $ZnO$, $ZnS$, $MgS$, $SnO_2$, $SiO_2$, $ZrO_2$, $PbO$, $NiO$, $Nb_2O_5$, $Ta_2O_5$, $Fe_2O_3$ oder $In_2O_3$ enthält. Auch ist es vorteilhaft, wenn mindestens ein Precursor in Form eines Metallalkoxids oder Metallchlorids vorliegt.

Auch ist es vorteilhaft, wenn die Lösung mindestens einen Alkohol und / oder Wasser enthält, um eine gute Lösung und Abscheidung des Verbindungshalbleiters zu ermöglichen.

Ferner ist es vorteilhaft, wenn durch eine Oxidation, insbesondere an der Umgebungsluft, der Oberfläche eines metallischen Substrats eine Schicht eines Metalloxid-Verbindungshalbleiters erzeugt wird. Auf diese Weise läßt sich ein Oxid des Metalls des Substrats auf einfache Weise erzeugen. Wird z.B. eine Zinkplatte als Substrat verwendet, so würde das enstehende Zinkoxid als Metallchalkogenid-Verbindungshalbleiter dienen. Die Zinkplatte könnte dann als Rückkontakt dienen.

Vorteilhafterweise wird das Inkontaktbringen von Substrat und Lösung durch ein Dip-Coating- oder ein Spin-Coating-Verfahren bewirkt. Beim Dip-Coating-Verfahren wird durch ein Eintauchen/Ausziehen des Substrats in die Lösung bzw. aus der Lösung eine Schicht auf das Substrat aufgebracht. Beim Spin-Coating-Verfahren wird die Lösung auf ein rotierendes Substrat aufgebracht. Beide Verfahren ermöglichen eine Beschichtung des Substrats mit einer hohen Oberflächengüte und hoher Gleichmäßigkeit.

In einer vorteilhaften Ausgestaltung des erfindungsgemäßen Verfahrens wird das Substrat zur Beschichtung mit einer vorbestimmbaren Ausziehgeschwindigkeit aus der Lösung gezogen. Dabei ist es vorteilhaft, wenn die Ausziehgeschwindigkeit konstant ist. Besonders vorteilhaft ist es, wenn die Ausziehgeschwindigkeit des Substrats kleiner als 3 mm/s ist. Damit läßt sich eine besonders hohe Oberflächengüte der Halbleiterschicht erzeugen, die für die guten Ladungsübergänge zur Schottky-Metallschicht von Bedeutung ist, die leitend mit der Halbleiterschicht in Kontakt steht.

Um eine gleichmäßige Beschichtung des Substrats zu ermöglichen, ist es vorteilhaft, daß das Substrat mit einer steuerbaren Vorrichtung aus der Lösung gezogen wird.

Mit Vorteil findet eine Hydrolyse-Reaktion zwischen dem Precursor auf dem Substrat und Luftfeuchte statt, um eine Metalloxid-Halbleiterschicht zu erreichen. Dabei verdunstet Alkohol und / oder das Wasser auf dem Substrat.

Bei der Bildung einer Sulfidschicht, ist es vorteilhaft, wenn die Sulfidierungs-Reaktion zwischen dem Precursor auf dem Substrat und dem Schwefelwasserstoff stattfindet.

Mit Vorteil wird nach der Hydrolyse-Reaktion und / oder nach der Sulfdierungs-Reaktion das beschichtete Substrat für eine vorbestimmbare Zeit zwischengetempert, wobei es besonders vorteilhaft ist, wenn die Zwischentemperung bei 200°C bis 500°C durchgeführt wird. Vorteilhaft ist es auch, wenn die Zwischentemperung zwischen 1 min und 20 min dauert.

Nach der Zwischentemperung ist es vorteilhaft, das beschichtete Substrat zu kühlen.

Für eine Abscheidung einer Metalloxid-Halbleiterschicht auf dem Substrat ist es vorteilhaft, den Auziehvorgang aus der Lösung, die Hydrolyse-Reaktion und das Zwischentempern mindestens zweimal zu wiederholen, da dabei eine gleichmäßige Halbleiterschicht einer gewünschten Dicke erzeugt wird. Dabei ist es vorteilhaft, die Beschichtung solange fortzusetzen, bis die Dicke der Halbleiterschicht zwischen 100nm und $1\mu m$ beträgt.

Nach Abschluß der Beschichtungsvorgangs ist es vorteilhaft, das Substrat bei Temperatur zwischen 400°C und 700°C in einem Ofen zu tempern. Besonders vorteilhaft ist es, die Temperung zwischen 1h und 3h dauern zu lassen.

Vorteilhafterweise wird vor dem Inkontaktbringen mit der Lösung eine Kontaktschicht auf dem Substrat und nach dem Tempern eine Metallschicht auf der Halbleiterschicht angeordnet. Auch eine andere Beschichtungsfolge, nämlich, daß vor dem Inkontaktbringen mit der Lösung eine Metallschicht auf dem Substrat und nach dem Tempern eine Kontaktschicht auf der Halbleiterschicht angeordnet wird, ist vorteilhaft.

Die Metallschicht besteht vorteilhafterweise aus Platin, Palladium, Nickel, Gold oder Silber. Sie wird vorteilhafterweise durch Sputtern, Elektonenstrahlverdampfen oder ein Elektrolyseverfahren aufgebracht.

Die Beschichtung mit der Metallschicht erfolgt vorteilhafterweise bis zu einer Schichtdicke von 20nm.

Besonders vorteilhaft ist es, wenn in einem erfindungsgemäßen Verfahren als Substrat ein Glaskörper mit mindestens einer ebenen Fläche verwendet wird. Auf der mindestens einen ebenen Fläche lassen sich Beschichtungen in besonders guter und einfacher Weise vornehmen.

Die Erfindung wird nachfolgend unter Bezugnahme auf die Figur der Zeichnung an mehreren Ausführungsbeispielen näher erläutert. Es zeigen:

Fig. 1    eine schematische dreidimensionale Ansicht einer ersten Ausführungsform eines erfindungsgemäßen Halbleiterbauelements;

Fig. 2    eine schematische dreidimensionale Ansicht einer zweiten Ausführungsform eines erfindungsgemäßen Halbleiterbauelements;

Fig. 3    eine schematische dreidimensionale Ansicht einer dritten Ausführungsform eines erfindungsgemäßen Halbleiterbauelements;

Fig. 4.    ein Beispiel für spektrale Empfindlichkeit eines erfindungsgemäßen Halbleiterbauelements;

Fig. 5    ein Beispiel für die Selektivität eines Verbindungshalbleiters für UV-Strahlung.

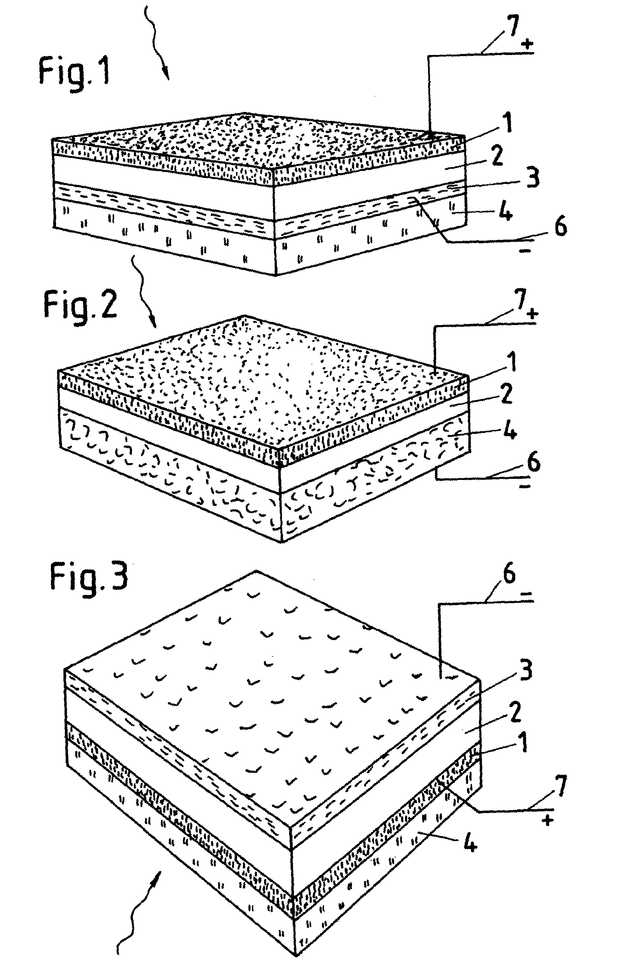

In Fig. 1 ist eine dreidimensionale Ansicht einer Ausführungsform eines erfindungsgemäßen Halbleiterbauelements dargestellt, das in einem UV-Sensorsystem verwendet wird.

Das Halbleiterbauelement weist mehrere parallele Schichten 1, 2, 3 auf, die auf einem Substrat 4 angeordnet sind. Als Substrat 4 dient hier Float-Glas mit zwei ebenen Oberflächen.

Auf dem Substrat 4 ist als elektrischer Kontakt eine Kontaktschicht 3 aus Zinnoxid als TCO (transparent conducting oxide) angeordnet. Das Zinnoxid ($SnO_2$) ist mit Fluor dotiert. In einer alternativen Ausgestaltung wird die Kontaktschicht 3 aus einem Metall, wie z.B. Zink, Aluminium gebildet.

Alternativ kann auch eine Metalltafel als Substrat 4 verwendet werden. Diese Metalltafel weist auf der für die Beschichtung vorgesehenen Seite eine eigene, leitende Oxidschicht als Kontaktschicht 3 auf.

Auf der Kontaktschicht 3 ist eine Halbleiterschicht 2 aus einem Metallchalkogenid-Verbindungshalbleiter als optisches Absorptionsmittel angeordnet. Im vorliegenden Fall besteht die Halbleiterschicht 2 aus dem Metalloxid-Verbindungshalbleiter $TiO_2$, wobei grundsätzlich auch andere Metallchalkogenid-Verbindungshalbleiter, wie ZnO, ZnS, MgS, $SnO_2$, $SiO_2$, $ZrO_2$, PbO, NiO, $Nb_2O_5$, $Ta_2O_5$, $Fe_2O_3$ oder $In_2O_3$ verwendbar sind. Die Metallchalkogenid-Verbindungshalbleiter dienen dabei als optische aktive Medien (optisches Absorbermaterial) und nicht als Trägermaterial.

Auch Mischungen und / oder Schichtungen mindestens zwei dieser Metallchalkogenid-Halbleiter sind möglich. Die Halbleiterschicht 2 aus einem Metalloxid-Verbindungshalbleiter dient als Absorber für einfallende elektromagnetische Strahlung, insbesondere UV-Strahlung.

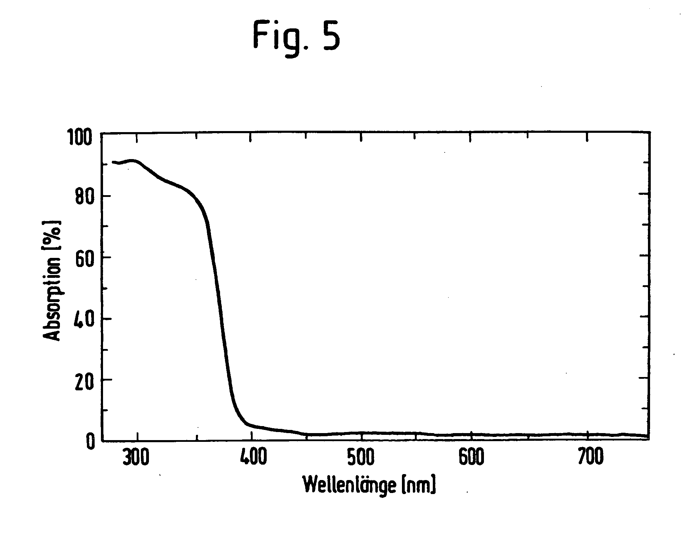

Diese Halbleiterschicht 2 aus $TiO_2$ ist 300nm dick, transparent im Wellenlängenbereich des sichtbaren Licht und weist eine nanokristalline Anatase-Struktur auf. Die Halbleiterschicht 2 ist "visible blind", d.h. die Halbleiterschicht 2 ist für elektromagnetische Strahlung im Wellenlängenbereich des sichtbaren Lichts nicht sensitiv (siehe Fig. 5). Die Halbleiterschicht 2 weist dabei eine besonders kompakte, ebene Oberfläche auf, da dadurch die elektrischen Kontakteigenschaften mit einer Metallschicht 1 (s.u.) und der Kontaktschicht 3 verbessert werden. Auch wird der Parallelwiderstand der Diodenschaltung verringert.

Dies wird durch eine besonders kleine Korngröße in der Halbleiterschicht 2 erreicht. Die Korngröße der Halbleiterschicht 2 liegt hier im Bereich von 10nm. Dabei wird eine besonders große Berührungsfläche mit der Unterlage erreicht. Eine solche Halbleiterschicht 2 ist auch optisch glatt. Insbesondere ist z.B. bei $TiO_2$ eine nichtporöse Schicht transparent, während eine poröse Schicht Licht streut und weiß erscheint.

Zur Bildung eines Schottky-Kontaktes ist auf die Halbleiterschicht 2 eine Metallschicht 1 aus Platin aufgebracht. Alternativ können auch Gold, Palladium, Nickel oder Silber als Metall verwandt werden. Die Metallschicht 1 ist 10nm dick und transmittiert auftreffende UV-Strahlung (Pfeil A) zu ca. 20-30% in die darunterliegende Halbleiterschicht 2 aus $TiO_2$. Der Rest der einfallenden Strahlung wird reflektiert.

Fällt auf das erfindungsgemäße Halbleiterbauelement UV-Strahlung (Pfeil A; Wellenlänge kleiner als 400nm), so werden in der Halbleiterschicht 2 durch die absorbierte Strahlung Ladungsträgerpaare (Elektronen, Löcher) erzeugt. Diese Ladungsträgerpaare werden in einem Grenzbereich an der Metallschicht 1 und der Halbleiterschicht 2 liegenden Raumladungszone (Schottky-Kontakt) getrennt.

Durch die Strahlungseinwirkung fließt ein Strom über einen Pluspol 7, der als Golddraht mit der Metallschicht 1 verbunden ist, und einem Minuspol 6, der mit einem Golddraht mit der Kontaktschicht 3 verbunden ist.

Die Größe des Substrats 4 hängt vom Anwendungszweck ab, wobei durch das erfindungsgemäße Verfahren Substrate 4 mit Flächen zwischen einem Quadratmillimeter bis zu mehreren Quadratmetern beschichtbar sind.

Im vorliegenden Beispiel ist das Substrat 4 ca. 30cm$^2$ groß. Durch Trennschleifen wird es in Chips mit einer Fläche von 20mm$^2$, die gut in einem als Handgerät ausgebildeten UV-Sensorsystem verwendbar sind. Grundsätzlich ist es aber möglich, erfindungsgemäße Halbleiterbauelemente auch mit wesentlich größeren Substraten 4, z.B. in Fensterscheiben, zu verwenden. Aus solchen großen Substraten 4 können durch kostengünstige Materialbearbeitungsverfahren eine Vielzahl von identischen Halbleiterbauelementen erzeugt werden.

Eine Anwendungsmöglichkeit eines erfindungsgemäßen Halbleiterbauelements ist ein UV-Strahlungsmeßgerät, das gesundheitsrelevante Strahlungsmengen erfaßt. Ein solches Gerät ist sinnvoll, da ein Mangel an UV-Strahlung, wie er besonders in den Wintermonaten auftritt, körperliches und seelisches Unwohlsein auslösen kann.

Dabei ist es wichtig, daß die Strahlungsmengen nicht einfach addiert werden, da z.B. eine bestehender Mangel nicht durch eine kurzzeitige, intensive Bestrahlung (z.B. Sonnenbrand) ausgeglichen werden kann.

So verfügt das Sensorsystem über ein Auswertungsmittel, mit dem bestimmte "Ausreißer" (z.B. schmale, hohe Peaks mit kurzzeitig hoher Strahlenbelastung) bei der Kumlierung der Strahlungsdosis nicht berücksichtigt werden. Wohl aber werden diese Ausreißer angezeigt und gespeichert, um den Benutzer auch über diese gesundheitsrelevanten Werte zu informieren.

Das erfindungsgemäße Gerät zeigt die Kumulierung der UV-Strahlungsmenge als Ist-Wert an. Dieser Ist-Wert wird mit einem vorgebbaren Soll-Wert verglichen. Ist die Differenz

$$\texttt{(Ist-Wert) - (Soll-Wert)}$$

negativ, d.h. liegt ein Mangel vor, so wird ein entsprechendes optisches und / oder akustisches Signal gesetzt. Darüber hinaus ist es vorteilhaft, eine positive Differenz in jedem Fall zu annullieren und nur den Zeitpunkt ihres Beginns als Signal auszugeben. Vorteilhaft ist es weiter, die Kumulierung synchron mit dem Sonnenzyklus tageweise vorzunehmen. Weiterhin ist es notwendig, bei der Kumulierung der Tageswerte alle positiven Differenzen zu annullieren. So kann eine Tages-, Wochen-, Monats- oder Jahresbilanz ausgegeben werden.

Die Miniaturformen bekannter UV-Sensoren wie auch die von Mikroprozessoren erlaubt es, einem UV-Meßgerät für den o.g. Einsatzzweck zum Beispiel die Form einer Armbanduhr, eines Fahrradcomputers oder eines Stickers zu geben. Grundsätzlich wird das an sich analoge Signal aus dem UV-Sensor digitalisiert und mit einem Hardwareumfang, der z.B. dem des Fahrradcomputers entspricht, für die o.g. Aufgaben aufbereitet.

Wenn ein Meßgerät der beschriebenen Art von einem Benutzer getragen wird, so gibt der gemessene Wert die tatsächlich vom Benutzer empfangene Strahlungsdosis nicht vollständig wieder, da der Einstrahlungsquerschnitt des Meßgeräts und des Benutzers unterschiedlich ist. Das Auswertungsmittel berücksichtigt diesen Tatbestand durch einen Korrekturfaktor, der u.U. auch adaptiv den tatsächlichen Einstrahlungen anpaßbar ist.

Ein erfindungsgemäßes Halbleiterbauelement kann auch in einem elektronischen Bauteil verwendet werden, die ein breites Einsatzgebiet hat.

Im folgenden wird ein erstes erfindungsgemäßes Verfahren beschrieben, mit dem ein Halbleiterbauelement mit einem Metalloxid-Verbindungshalbleiter herstellbar ist.

Dazu wird hier die Beschichtung des Substrats 4 mit einem Tauch-Vorgang (Dip-coating) verwendet. Dabei findet ein Sol-Gel-Prozeß mit einer Hydrolyse und Kondensation (beim späteren Tempern) statt.

Bei der Herstellung des Halbleiterbauelements werden folgende Schritte durchgeführt.

1. Das Substrat 4 ist hier eine rechteckige Glasscheibe mit einer Fläche von 4cm$^2$ aus Float-Glas. Eine der beiden größeren Seitenflächen dieses Substrats 4 ist hier bereits mit einer Kontaktschicht 1 aus fluordotiertem $SnO_2$ als TCO (transparent conduction oxide) beschichtet.

2. Das Substrat 4 wird in einem Ultraschallbad nacheinander in Ethanol, Wasser und wieder Ethanol für jeweils 5 min gereinigt.
Zur Beschleunigung der anschließenden Trocknung wird das Substrat 4 anschließend mit einem Stickstoffstrahl abgeblasen.

3. Dieses Substrat 4 wird dann in eine Lösung aus 90% Isopropanol und 10% Tetraisopropyltitanat eingetaucht. Die Tauchzeit beträgt 2s, die Ausziehgeschwindigkeit 5mm/s. Das Tetrapropyltitanat dient dabei als Precursor für die Halbleiterschicht aus dem Metalloxid-Verbindungshalbleiter $TiO_2$. Beim Herausziehen des Substrats 4 scheidet sich dabei ein Precursorfilm auf der Oberfläche des Subtrats ab.
In alternativen Ausführungsformen des erfindungsgemäßen Verfahrens werden andere Alkohole, wie Methanol, Ethanol oder Butanol verwendet. Auch können andere Precursor Verbindungshalbleiter in der Lösung verwendet werden.
In ebenfalls alternativen Ausführungsformen wird die Beschichtung nicht durch Eintauchen, sondern durch Spin-coating durchgeführt. Dabei wird das Substrat 4 in Rotation versetzt und die Lösung mit dem Metalloxid-Verbindungshalbleiter auf das Substrat 4 getropft. Durch die Fliehkräfte bildet sich eine dünne Schicht auf dem Substrat 4 aus. Die Viskosität der aufgetropften Lösung muß etwas höher als beim Dip-coating sein, damit sich eine gleichmäßige Schicht ausbildet. Die weiteren Verfahrensschritte bei der Vor- und Nachbereitung, wie Trocknen, Zwischentempern und Tempern, erfolgen analog zum Dip-coating Verfahren.
In einer ebenfalls alternativen Ausführung wird die Halbleiterschicht 2 durch Sprühpyrolyse aufgebracht, wobei eine Tetraisopropyltitanat und Isopropanol Lösung unter hohem Druck auf ein ca. 200°C warmes Substrat 4 gesprüht wird. Bei der Verdampfung des Lösungsmittels findet eine Reaktion zu $TiO_2$ statt. Auch hier erfolgen die Vor- und Nachbehandlungsschritte in analoger Weise zum Dip-coating Verfahren.
Grundsätzlich ist es auch möglich, die Beschichtung mit Hilfe des Screenprinting-Verfahrens oder durch ein Sputter-Verfahren herzustellen.

4. Das Substrat 4 wird mit einer konstanten Ausziehgeschwindigkeit von 1mm/s aus der Lösung gezogen, wobei das Tetraisopropyltitanat an der Luft mit der Luftfeuchtigkeit zur $TiO_2$ reagiert (Hydrolyse-Reaktion).

5. Nach dem Ausziehen aus der Lösung wird das beschichtete Substrat 4 für 2 min bei ca. 200°C in einem Ofen zwischengetempert. Dabei findet eine Kondensationsreaktion statt und es verdunstet am Substrat 4 haftender Alkohol.

6. Die Verfahrensschritte 3 bis 5 werden sechsmal wiederholt, wobei nach Verfahrensschritt 5 und vor dem Verfahrensschritt 3 das Substrat 4 durch Druckluft abgekühlt wird.
Die Handhabung des Substrats 4 erfolgt mit Hilfe eines computergesteuerten 3-Achsen Roboters, der eine besonders exakte Führung der Prozeßparameter (Ausziehgeschwindigkeit, Ausziehdauer, Zwischentemperdauer) sicherstellt.

7. Nach den verschiedenen Tauchvorgängen wird das beschichtete Substrat 4 bei ca. 450°C in einem Ofen für 2h getempert.
Nach Abschluß des Temperns liegt eine Halbleiterschicht 2 vor, die eine Schichtdicke zwischen 200nm und 300nm aufweist.

8. Nach dem Abkühlen wird auf die Halbleiterschicht 2 eine Metallschicht 1 aus Platin aufgebracht. Die Schichtdicke beträgt 10nm. Die Metallschicht wird durch Sputtern aufgebracht.
In einer alternativen Ausführungsform des erfindungsgemäßen Verfahrens wird die Metallschicht 1 durch ein Elektronenstrahlverdampfungsverfahren oder ein Elektrolyseverfahren aufgebracht. Als Metalle zum Beschichten kommen auch Silber, Palladium, Nickel oder Gold in Frage.

9. Nach dem Abschluß der Beschichtungsvorgänge werden an der Metallschicht 1 und der Kontaktschicht 3 Golddrähte angeschlossen, um die bei Strahlungseinfall entstehende Spannung abgreifen zu können.

In einer alternativen Ausführungsform des Verfahrens wird das Substrat 4 zuerst mit einer Metallschicht 1 beschichtet. Anschließend wird auf dieses Schicht mit einem Dip-Coating- oder Spin-Coating-Verfahren eine Halbleiterschicht 2 aufgebraucht. Auf diese wird dann schließlich die Kontaktschicht 3 aufgebracht. Die obengenannten Verfahrensschitte für die Beschichtung mit dem Metalloxid-Verbindungshalbleiter werden dabei analog verwendet, wobei die Verfahrenschritte für das Aufbringen der Metallschicht diesen vorgeschaltet sind.
Auch in einer zweiten Ausführungsform des erfindungsgemäßen Verfahrens wird zur Beschichtung des Substrats 4 auch das Dip-coating verwendet. Dabei findet ein Sol-Gel-Prozeß mit einer Hydrolyse und Kondensation für die oxidische Komponente und eine heterogene Sulfidierung mit gasförmigem Schwefelwasserstoff für eine sulfidische Komponente statt. Als Vorlage für die Sulfidierung dienen metallsalzhaltige Flüssigkeitsfilme, die auf das vorgelegte Oxidgitter ebenfalls mittels Dipcoating aufgezogen werden. Durch Tempern wird nach jedem Coating-Prozess die Hydrolyse oder die Sulfidierung abgeschlossen.

Bei dieser zweiten Ausführungsform für die Herstellung des Halbleiterbauelements werden folgende Schritte durchgeführt.

1. Das Substrat 4 ist hier eine quadratische Glasscheibe mit einer Fläche von ca. 30 cm$^2$ aus Float-Glas. Eine Substratseite ist bereits mit einer Kontaktschicht 3 aus fluordotiertem SnO$_2$ als TCO (transparent conduc-tion oxide) beschichtet.

2. Das Substrat 4 wird in einem Ultraschallbad in Isopropanol und einem Netzmittel 30 Sekunden gereinigt. Die Ultraschalleinwirkung wird dabei auf 1 bis 5 Sekunden begrenzt. Bei einer Austauchgeschwindigkeit von 0,5 mm/ sec verläßt die gereinigte Scheibe trocken das Reinigungsbad.

3. Dieses Substrat 4 wird dann in eine Lösung aus Isopropanol, Tetraisoproplytitanat, Wasser und Diethanolamin eingetaucht. Die Tauchzeit beträgt 2 Sekunden, die Austauchgeschwindigkeit 1 mm/s. Das Tetraisopropyltitanat dient dabei als Precursor für die Halbleiterschicht aus dem Metalloxid-Verbindungshalbleiter TiO$_2$. Beim Herausziehen des Substrats 4 scheidet sich dabei ein Precursorfilm auf der Oberfläche des Substrats 4 ab.
In alternativen Ausführungsformen werden andere Alkohole, wie Methanol, Ethanol oder Butanol verwendet. Auch können andere die Komponenten des späteren Halbleiters enthaltenden Precursormaterialen in der Lösung verwendet werden.
In ebenfalls alternativen Ausführungsformen wird die Beschichtung nicht durch Eintauchen, sondern durch Spin-coating durchgeführt. Dabei wird das Substrat 4 in Rotation versetzt und die Lösung mit dem Metalloxid-Verbindungshalbleiter auf das Substrat 4 getropft. Durch die Fliehkräfte bildet sich eine dünne Schicht auf dem Substrat 4 aus. Die Viskosität der aufgetropften Lösung muß etwas höher als beim Dipcoating sein, damit sich eine gleichmäßige Schicht ausbildet. Die weiteren Verfahrensschritte bei der Vor- und Nachbereitung, wie Trocknen, Zwischentempern und Tempern, erfolgen analog zum Dip-coating Verfahren.
In einer ebenfalls alternativen Ausführung wird die Halbleiterschicht 2 durch Sprühpyrolyse aufgebracht, wobei eine Tetraisopropyltitanat und Isopropanol Lösung unter hohem Druck auf ein ca. 200°C warmes Substrat 4 gesprüht wird. Bei der Verdampfung des Lösungsmittels findet eine Reaktion zu TiO$_2$ statt. Auch hier erfolgen die Vor- und Nachbehandlungsschritte in analoger Weise zum Dip-coating Verfahren.
Grundsätzlich ist es auch möglich, die Beschichtung mit Hilfe des Screenprinting-Verfahrens oder durch ein Sputter-Verfahren herzustellen.

4. Das Substrat 4 wird beim Tauchverfahren mit einer konstanten Ausziehgeschwindigkeit von 1mm/s aus der Lösung gezogen, wobei das Tetraisopropyltitanat an der Luft mit der Luftfeuchtigkeit zur TiO$_2$ reagiert (Hydrolyse-Reaktion) und eine optisch homogene Schicht bildet

5. Nach dem Austauchen aus der Lösung wird das beschichtete Substrat 4 für 20 min bei ca. 470°C in einem Ofen zwischengetempert. Dabei verdunstet am Substrat 4 haftender Alkohol.

6. Anschließend erfolgt mit den gleichen Parametern ein Dip-coating mit der alkoholischen Metallsalzlösung. Dabei bleibt adhäsiv ein homogener Film dieser Lösung auf dem vorgelegten Grundgitter haften. In Analogie zur Hydrolyse-Reaktion wird nun unter einer Gasglocke ein Gemisch aus Stickstoff und Schefelwasserstoff über das Substrat geleitet. Dabei wächst das sich bildende Zinksulfid mit seiner eigenen Kristallstruktur (Zinkblende-Typ) in das Titandioxid ein.

7. Die Verfahrensschritte 3 bis 6 werden sechsmal wiederholt, wobei nach jedem Tempern das Substrat in ruhender Luft abgekühlt wird.
Die Handhabung des Substrats 4 erfolgt mit Hilfe eines computergesteuerten 3-Achsen Roboters, der eine hinreichend exakte Führung der Prozeßparameter (Ausziehgeschwindigkeit, Ausziehdauer, Zwischentemperdauer) sicherstellt.

8. Nach den verschiedenen Tauchvorgängen wird das beschichtete Substrat 4 bei ca. 450°C in einem Ofen für 2 Stunden getempert.
Nach Abschluß des Temperns liegt eine Halbleiterschicht 2 vor, die eine Schichtdicke zwischen 200nm und 300nm aufweist.

9. Nach dem Abkühlen wird auf die Halbleiterschicht 2 eine Metallschicht 1 aus Platin aufgebracht. Die Schichtdicke beträgt 10nm. Die Metallschicht wird durch Sputtern aufgebracht.
In einer alternativen Ausführungsform des erfindungsgemäßen Verfahrens wird die Metallschicht 1 durch ein Elektronenstrahlverdampfungsverfahren oder ein Elektrolyseverfahren aufgebracht. Als Metalle zum Beschichten kommen auch Silber, Palladium, Nickel oder Gold in Frage.

10. Nach dem Abschluß der Beschichtungsvorgänge werden an der Metallschicht 1 und der Kontaktschicht 3 Golddrähte angeschlossen, um die bei Strahlungseinfall entstehende Spannung abgreifen zu können.

In einer alternativen Ausführungsform des Verfahrens wird das UV-transparente Substrat 4 zuerst mit einer transparenten Metallschicht 1 beschichtet. Anschließend wird auf diese Schicht mit einem Dip-Coating- oder Spin-Coating-Verfahren eine Halbleiterschicht 2 aufgebracht. Auf diese wird dann schließlich die Kontaktschicht 3 aufgebracht. Die obengenannten Verfahrensschitte für die Beschichtung mit dem Metalloxid-Verbindungshalbleiter werden dabei analog verwendet, wobei die Verfahrensschritte für das Aufbringen der Metallschicht diesen vorgeschaltet sind.

In Fig. 2 wird eine zweite Ausführungsform des erfindungsgemäßen Halbleiterbauelements dargestellt. In Abwandlung, des unter Fig. 1 abgebildeten Gegenstands, ist hier zwischen der Halbleiterschicht 2 und dem Substrat 4 keine Kontaktschicht angeordnet. Das Substrat 4 besteht hier aus Metall, das naturgemäß eine Oxidschicht aufweist. Diese ist leitfähig, so daß eine gesonderte Kontaktschicht nicht vorliegen muß.

In Fig. 3 ist eine dritte Ausführungsform dargestellt, bei der die Reihenfolge der Metallschicht 1 und der Kontaktschicht 3 gegen über der ersten Ausführungsform invertiert ist, d.h. die Metallschicht 1 ist auf dem Substrat 4 angeordnet. Über der Metallschicht 1 ist dann die Halbleiterschicht 2 angeordnet, auf der dann die Kontaktschicht 3 angeordnet ist.

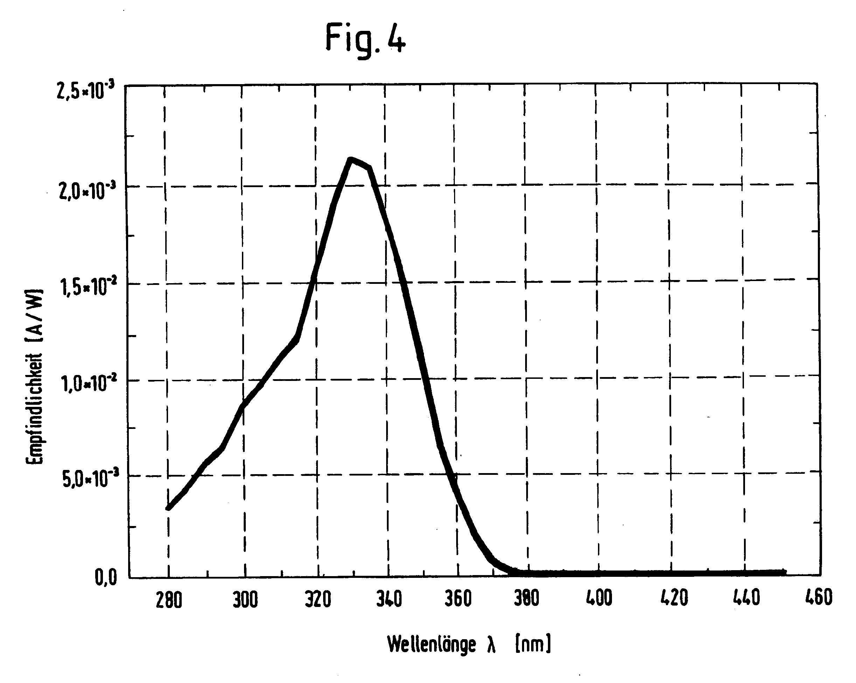

In Fig. 4 ist eine beispielhafte Spektralkennlinie für eine Ausführungsform eines erfindungsgemäße Halbleiterelements in einem kompletten Bauteil dargestellt. Dabei wird dargestellt, welcher Stromfluß in Abhängigkeit von der eingestrahlten Wellenlänge erzeugt wird. Als Metallchalkogenid-Verbindungshalbleiter wird hier $TiO_2$ verwendet. Es ist deutlich zu erkennen, daß die spektrale Empfindlichkeit des verwendeten Metallchalkogenid-Verbindungshalbleiters ein Maximum bei einer Wellenlänge von 330nm aufweist.

In Fig. 5 ist eine Meßkurve dargestellt, in der auf der X-Achse die Wellenlänge der auf ein erfindungsgemäßes Halbleitermaterial ($TiO_2$) eingestrahlten Strahlung, auf der Y-Achse die Absorption dargestellt ist.

Dabei ist deutlich zu erkennen, daß im UV-Bereich unterhalb von 400nm die Absorption sehr hoch, oberhalb einer Wellenlänge von 400nm (sichtbares Licht) sehr niedrig ist. Ein Halbleitermaterial mit einer solchen Charakteristik "sieht" die längeren Wellenlängen nicht und weist damit eine hohe Sensivität ausschließlich für UV-Strahlung auf.

**Patentansprüche**

1.   Halbleiterbauelement zur Detektion von UV-Strahlung mit einem Substrat (4) wobei der Halbleiter mindestens einen Metallchalkogenid-Verbindungshalbleiter als optisches Absorbermaterial für UV-Strahlung aufweist oder aus ihm besteht und der Halbleiter mit einem Metall einen Schottky-Kontakt bildet, **gekennzeichnet durch** einen Schichtenstapel mit einer nanokristallinen Metallchalkogenid-Verbindungshalbleiterschicht (2), die

   a) auf einer Seite leitend mit einer elektrischen Kontaktschicht (3) oder leitend mit einem metallischen Substrat (4) und
   b) auf der anderen Seite leitend mit einer für UV-Strahlung zumindest teilweise transparenten Metallschicht (1) verbunden ist.

2.   Halbleiterbauelement nach Anspruch 1, **dadurch gekennzeichent,** daß der Halbleiter eine Mischung oder eine Schichtfolge mit mindestens zwei Metallchalkogenid-Verbindungshalbleitern aufweist.

3.   Halbleiterbauelement nach Anspruch 1 oder 2, **dadurch gekennzeichnet, daß** mindestens ein Metallchalkogenid-Verbindungehalbleiter $TiO_2$, ZnO, ZnS, MgS, $SnO_2$, $ZrO_2$, PbO, NiO, $Nb_2O_5$, $Ta_2O_5$, $Fe_2O_3$ oder $In_2O_3$ ist.

4.   Halbleiterbauelement nach mindestens einem der vorhergehenden Ansprüche, **dadurch gekennzeichnet, daß** der Halbleiter als Halbleiterschicht (2) auf einem Substrat (4) angeordnet ist.

5.   Halbleiterbauelement nach Anspruch 4, **dadurch gekennzeichnet, daß** der Halbleiter als Halbleiterschicht (2) auf dem Substrat (4) angeordnet ist, wobei zwischen der Halbleiterschicht (2) und dem Substrat (4) mindestens eine Zwischenschicht angeordnet ist.

6.   Halbleiterbauelement Anspruch 4 oder 5, **dadurch gekennzeichnet, daß** die Halbleiterschicht (2) eine Dicke von weniger als 1$\mu$m aufweist.

7.   Halbleiterbauelement nach mindestens einem der Ansprüche 4 bis 6, **dadurch gekennzeichnet, daß** die Halbleiterschicht (2) im wesentlichen eine Korngröße von kleiner als 20nm, insbesondere kleiner als 10nm aufweist.

8.   Halbeleiterbauelement nach mindestens einem der Ansprüche 4 bis 8, **dadurch gekennzeichnet, daß** die Halbleiterschicht (2) mit Niob und / oder Tantal dotiert ist.

9.   Halbleiterbauelement nach mindestens einem der vorhergehenden Ansprüche, **dadurch gekennzeichnet, daß** das Substrat (4) zur Bildung eines Schottky-Kontakts als Metall, insbesondere Platin,

Palladium, Nikkel, Gold oder Silber aufweist.

10. Halbleiterbauelement nach mindestens einem der vorhergehenden Ansprüche, **dadurch gekennzeichnet, daß** das Metall als Metallschicht (1) auf der Halbleiterschicht (2) angeordnet ist.

11. Halbleiterbauelement nach mindestens einem der vorhergehenden Ansprüche , **dadurch gekennzeichnet, daß** die Kontaktschicht (3) ein leitfähiges Material, insbesondere fluordotiertem $SnO_2$, $SnO_2/In_2O_3$, ZnO, Aluminium-dotiertem ZnO, Zink oder Aluminium aufweist oder aus diesem gebildet ist.

12. Halbleiterbauelement nach mindestens einem der vorhergehenden Ansprüche, **dadurch gekennzeichnet, daß** die Kontaktschicht (3) aus einem Oxid eines metallischen Substrats (4) gebildet ist.

13. Halbleiterbauelement nach mindestens einem der vorhergehenden Ansprüche, **dadurch gekennzeichnet, daß** auf dem Substrat (4) eine Kontaktschicht (3), darauf eine Halbleiterschicht, insbesondere eine $TiO_2$-Schicht als Halbleiterschicht (2) und darauf eine Platin-Schicht als Metallschicht (1) angeordnet ist.

14. Halbleiterbauelement nach mindestens einem der vorhergehenden Ansprüche, **dadurch gekennzeichnet, daß** auf dem Substrat (4) eine Platin-Schicht als Metallschicht, darauf eine Halbleiterschicht (2), insbesondere eine $TiO_2$-Schicht als Halbleiterschicht (2) und darauf als transparente Kontaktschicht (3) angeordnet ist.

15. Halbleiterbauelement nach mindestens einem der vorhergehenden Ansprüche, **dadurch gekennzeichnet, daß** das Substrat (4) ein Glaskörper, insbesondere aus Quarzglas, mit mindestens einer ebenen Fläche ist.

16. Halbleiterbauelement nach mindestens einem der vorhergehenden Ansprüche, **dadurch gekennzeichnet, daß** bei einer Bestrahlung des Halbleiterbauelements mit einer elektromagnetischen Strahlung, im Halbleiterbauelement ein Strom zwischen dem Metall (1) und dem elektrischen Kontakt (3) fließt.

17. Elektronisches Bauteil, das ein Halbleiterbauelement nach mindestens einem der vorhergehenden Ansprüche aufweist.

18. Sensorsystem für elektromagnetische Strahlung, das ein Halbleiterbauelement nach mindestens einem der Ansprüche 1 bis 16 und / oder ein elektronisches Bauteil nach Anspruch 17 aufweist.

19. Sensorsystem nach Anspruch 18, **dadurch gekennzeichnet, daß** es in einem tragbaren Gerät, insbesondere einem Handgerät, einer tragbaren Uhr, einem Anstecker oder Fahrradcomputer angeordnet ist.

20. Sensorsystem nach Anspruch 18 oder 19, **gekennzeichnet durch** ein Mittel zur Erfassung einer kumulierten Strahlungsdosis.

21. Sensorsystem nach Anspruch 20, **gekennzeichnet durch** ein Auswertungsmittel, das eine Differenz der kumulierten Strahlungsdosis zu einem vorgebbaren Wert einer Strahlungsdosis ermittelt.

22. Sensorsystem nach Anspruch 21, **dadurch gekennzeichnet, daß** das Auswertungsmittel die Differenz automatisch optisch und / oder akustisch anzeigt.

23. Sensorsystem nach Anspruch 21 oder 22, **dadurch gekennzeichnet, daß** das Auswertungsmittel gemessene Ausreißer der Strahlungsdosis detektiert.

24. Sensorsystem nach Anspruch 23 **dadurch gekennzeichnet, daß** das Auswertungsmittel die Ausreißer bei der Kumulierung der Strahlungsdosis nicht berücksichtigt.

25. Sensorsystem nach mindestens einem der Ansprüche 21 bis 24, **dadurch gekennzeichnet, daß** das Auswertungsmittel ein Korrekturmittel aufweist, um den tatsächlichen Einstrahlungs-Querschnitt des Sensorsystem auf einen Eintrahlungs-Querschnit einer Person umzurechnen.

26. Verfahren zur Herstellung eines Halbleiterbauelements zur Detektion von UV-Strahlung nach Anspruch 1,
**dadurch gekennzeichnet, daß**
zum Aufbau eines Schichtenstapels mit einem Substrat (4) und einer Halbleiterschicht (2) mit mindestens einem nanokristallinen **Metallchalkogenid-Verbindungehalbleiter,** das Substrat (4) mit einer Lösung in Kontakt gebracht wird, in der mindestens ein Precursor eines **Metallchalkogenid-Verbindungahalbleitere** gelöst und / oder suspendiert ist.

27. Verfahren nach Anspruch 26, **dadurch gekennzeichnet, daß** das Substrat (4) nacheinander mit mindestens zwei verschiedene Precursor-Lösungen in Kontakt gebracht wird.

28. Verfahren nach Anspruch 26 oder 27, **dadurch gekennzeichnet, daß** die Lösung mindestens einen Precursor der Metallchalkogenid-Verbindungshalbleiter $TiO_2$, ZnO, ZnS, MgS, $SnO_2$, $ZrO_2$, PbO, NiO, $Nb_2O_5$, $Ta_2O_5$, $Fe_2O_3$ oder $In_2O_3$ enthält.

**29.** Verfahren nach mindestens einem der Ansprüche 26 bis 28, **dadurch gekennzeichnet, daß** die Lösung mindestens einen Precursor in Form eines Metallalkoxids oder Metallchlorids aufweist.

**30.** Verfahren nach mindestens einem der Ansprüche 26 bis 29, **dadurch gekennzeichnet, daß** die Lösung mindestens einen Alkohol und / oder Wasser enthält.

**31.** Verfahren nach mindestens einem der Ansprüche 26 bis 30, **dadurch gekennzeichnet, daß** durch eine Oxidation, insbesondere an der Umgebungsluft, der Oberfläche eines metallischen Substrats (4) eine Schicht des Metalloxid-Verbindungshalbleiters erzeugt wird.

**32.** Verfahren nach mindestens einem der Ansprüche 26 bis 31, **dadurch gekennzeichnet, daß** zur Bildung einer Sultidochicht auf einem metallischen Substrat (4) ein Gasgemisch aus Stickstoff und Schwefelwasserstoff mit dem Substrat (4) in Kontakt gebracht wird.

**33.** Verfahren nach mindestens einem der Ansprüche 26 bis 32, **dadurch gekennzeichnet, daß** das Inkontaktbringen von Substrat (4) und Lösung durch ein Spin-Coating-Verfahren bewirkt wird.

**34.** Verfahren nach mindestens einem der Ansprüche 26 bis 33, **dadurch gekennezeichnet,** daß das Inkontaktbringen von Substrat (4) und Lösung durch ein Dip-Coating-Verfahren bewirkt wird.

**35.** Verfahren nach Anspruch 34, **dadurch gekennzeichnet, daß** das Substrat (4) zur Beschichtung mit einer vorbestimmbaren Ausziehgeschwindigkeit aus der Lösung gezogen wird.

**36.** Verfahren nach Anspruch 35, **dadurch gekennzeichnet, daß** die Ausziehgeschwindigkeit des Substrats (4) aus der Lösung konstant ist.

**37.** Verfahren nach Anspruch 35 oder 36, **dadurch gekennzeichnet, daß** die Ausziehgeschwindigkeit des Substrate (4) aus der Lösung kleiner als 3mm/s ist.

**38.** Verfahren nach mindestens einem der Ansprüche 26 bis 37, **dadurch gekennzeichnet, daß** das Substrat (4) mit einer steuerbaren Vorrichtung aus der Lösung gezogen wird.

**39.** Verfahren nach mindestens einem der Ansprüche 26 bis 38, **dadurch gekennzeichnet, daß** eine Hydrolyse-Reaktion zwischen dem Precursor auf dem Substrat (4) und Luftfeuchte stattfindet.

**40.** Verfahren nach mindestens einem der Ansprüche 26 bis 39, **dadurch gekennzeichnet, daß** eine Sulfidierungs-Reaktion zwischem dem Precursor auf dem Substrat (4) und dem Schwefelwasserstoff stattfindet.

**41.** Verfahren nach Anspruch 40, **dadurch gekennzeichnet, daß** nach der Hydrolyse-Reaktion und / oder der **Sulfidierungs-Reaktion** das beschichtete Substrat (4) für eine vorbestimmbare Zeit zwischengetempert wird.

**42.** Verfahren nach Anspruch 41, **dadurch gekennzeichnet, daß** die Zwischentemperung in einem Temperaturbereich von 200°C bis 500°C durchgeführt wird.

**43.** Verfahren nach Anspruch 41 oder 42, **dadurch gekennzeichnet, daß** die Zwischentemperung zwischen 1min und 20min dauert.

**44.** Verfahren nach mindestens einem der Ansprüche 26 bis 43, **dadurch gekennzeichnet, daß** das beschichtete Substrat (4) nach der Zwischentemperung gekühlt wird.

**Claims**

**1.** Semiconductor component for the detection of UV radiation, having a substrate (4), the semiconductor including at least one metal chalcogenide compound semiconductor as optical absorber material for UV radiation or consisting of said compound semiconductor, and the semiconductor forming a Schottky contact with a metal,
**characterized by**
a layer stack comprising a nanocrystalline metal chalcogenide compound semiconductor layer (2), which

a) on one side is conductively connected to an electrical contact layer (3) or is conductavely connected to a metallic substrate (4), and
b) on the other side is conductively connected to a metal layer (1) which is least partially transparent to UV radiation.

**Revendications**

**1.** Elément semiconducteur pour la détection du rayonnement UV, doté d'un substrat (4), le semiconducteur présentant comme matériau d'absorption optique du rayonnement UV au moins un semiconducteur de liaison en chalcogénure de métal ou étant constitué de ce dernier et le semiconducteur formant un contact de Schottky avec un métal,

**caractérisé par**
un empilement de couches qui présente une couche nanocristalline (2) de semiconducteur de liaison en chalcogénure de métal qui est reliée

  a) sur un côté, de manière conductrice à une couche de contact électrique (3) ou de manière conductrice au substrat métallique (4) et
  b) sur l'autre côté, de manière conductrice à une couche métallique (1) au moins partiellement transparente vis à vis du rayonnement UV,

Fig.1

7
+
1
2
3
4
6
−

Fig.2

7
+
1
2
4
6
−

Fig.3

6
−
3
2
1
7
+
4

Fig. 4

# Fig. 5